# EUROPEAN PATENT APPLICATION

(11) **EP 4 624 366 A1**
(43) Date of publication of application: **01.10.2025**
(21) Application number: 23911286.5
(22) Date of filing: 12.09.2023
(51) Int. Cl.: B65G 1/04

(54) **CONVEYANCE VEHICLE SYSTEM**

(30) Priority: 27.12.2022 JP 2022209502
(71) Applicant: Murata Machinery, Ltd., Kyoto-shi, Kyoto 601-8326 (JP)
(72) Inventor: MOTOORI Yoichi, Inuyama-shi, Aichi 484-8502 (JP)
(74) Representative: Stöckeler, Ferdinand
(86) International application number: PCT/JP2023/033231
(87) International publication number: WO 2024/142502

(57) **Abstract**

A transport vehicle system (1) includes: a transport vehicle (3) having a traveling section (20), a holding section (13), a lifting drive section (14), a sliding section (11), and a transport vehicle control section (50); and a storage device (6) having a stocker (60) with racks (61) and a transfer device (70). Among a plurality of placing sections disposed on the uppermost row of the rack (61), at least one first placing section (65A) for storage and at least one second placing section (65B) for retrieval are set, and the transport vehicle control section (50) controls the traveling section (20), the lifting drive section (14), and the sliding section (11) so as to deliver the article (M) held by the holding section (13) to the first placing section (65A) and receive the article (M) placed on the second placing section (65B), in a state of being stopped at a specific stopping position.

## Description

### Technical Field

One aspect of the present invention relates to a transport vehicle system.

### Background Art

Patent Document 1 discloses a transport vehicle system including an overhead transport vehicle (transport vehicle) liftably provided with a holding section holding articles and a stocker storing articles. In the transport vehicle of Patent Document 1, a plurality of delivery sections are provided at the uppermost row of the stocker, and the transport vehicle is configured to pass directly over the delivery sections. The reception and delivery of articles between the transport vehicle and the stocker is performed by the transport vehicle, which stops directly above the delivery section, lifting and lowering the holding section.

### Citation List

### Patent Literature

[Patent Literature 1] Japanese Patent No. 3669057

### Summary of Invention

### Technical Problem

However, in the conventional transport vehicle system described above, in a case where a transport vehicle delivers an article to a stocker and then receives an article from the stocker, it is necessary to deliver the preceding article to one delivery section and then move to another delivery section to receive an article. Such moves are time-consuming and cause the transport efficiency of the entire system to decrease.

An object of one aspect of the present invention is therefore to provide a transport vehicle system that enables efficient storage and retrieval of articles between the transport vehicle and the stocker.

### Solution to Problem

The transport vehicle system according to one aspect of the present invention is a transport vehicle system including a transport vehicle configured to travel on a track provided on a ceiling of a building to transport an article, and a storage device configured to store the articles, in which the transport vehicle has a traveling section configured to travel on the track, a holding section configured to hold the article, a lifting drive section configured to raise and lower the holding section with respect to the traveling section, a sliding section configured to move the holding section and the lifting drive section in a horizontal direction with respect to the traveling section, and a transport vehicle control section configured to control the transport vehicle, the storage device has a stocker having a rack in which a plurality of placing sections arranged vertically and horizontally are disposed, and a transfer device configured to deliver the article to the placing sections, among the placing sections disposed in an uppermost row of the rack, at least one first placing section for storage and at least one second placing section for retrieval are set, and the transport vehicle control section controls the traveling section, the lifting drive section, and the sliding section so as to deliver the article held by the holding section to the first placing section and receive the article placed on the second placing section, in a state of being stopped at a specific stopping position.

In the transport vehicle system of this configuration, while stopped at the specific stopping position, the transport vehicle controls the traveling section, the lifting drive section, and the sliding section so as to deliver the article held by the holding section to the first placing section and receive the article placed on the second placing section, instead of performing storage and retrieval between the transport vehicle and the stocker after the transport vehicle stores an article in the delivery section (first placing section) in which the article is to be stored and then moves to the delivery section (second placing section) from which an article is to be retrieved. Consequently, articles are stored in the stocker without the need to move the transport vehicle, and articles are also retrieved from the stocker. As a result, efficient storage and retrieval of articles between the transport vehicle and the stocker is possible.

In the transport vehicle system according to an aspect of the invention, the first placing section and the second placing section may be set to be in a state of being disposed to sandwich a travel area of the transport vehicle in plan view viewed from above in a vertical direction, and the specific stopping position may be set between the first placing section and the second placing section in the plan view. In this configuration, control of a simple sliding section configured to move articles along one direction allows storage and retrieval of the articles to and from the stocker.

In the transport vehicle system according to an aspect of the invention, the stocker may have a first rack and a second rack disposed to face each other across the travel area of the transport vehicle in plan view viewed from above a vertical direction, the first placing section may be set on the first rack, and the second placing section may be set on the second rack, and the specific stopping position may be set between the first placing section and the second placing section in the plan view. In this configuration, control of a simple sliding section configured to move articles along one direction allows storage and retrieval of the articles to and from the stocker.

In the transport vehicle system according to an aspect of the present invention, the transport vehicle may further have a rotary section configured to rotate the holding section within a horizontal plane, the article may have a first end that is one end in one direction and a second end that is another end in the one direction and has a different shape from the first end, a positioning member may be provided in the placing section of the rack, the positioning member being configured to position the articles so that the first ends of the articles placed on the racks disposed to face each other, and the transport vehicle control section may rotate the rotary section so that the first end faces the second rack when the article is placed on the first placing section. In this configuration, there is no need to provide a mechanism on the storage device side, the mechanism being configured to adjust an orientation of an article M when placed on the placing section.

In the overhead transport vehicle according to one aspect of the present disclosure, in the track, a plurality of first rails extending in a first direction and being arrayed in a second direction orthogonal to the first direction and second rails extending in the second direction and being arrayed in the first direction may be disposed in a grid pattern, the transport vehicle may move in the first direction when the traveling section travels on a pair of the first rails adjacent to each other in the second direction, and may move in the second direction when the traveling section travels on a pair of the second rails adjacent to each other in the first direction. In this configuration, the transport vehicle can access the placing section by traveling from a plurality of directions, and a degree of freedom in disposing the storage device can increase compared to a transport vehicle system in which a transport vehicle travels along a rail in one direction, and thus storage and retrieval of articles can be performed more efficiently.

The transport vehicle system according to one aspect of the present invention, may further include a system controller configured to output to the transport vehicle a transport command instructing a transport destination of the article, in which the system controller outputs to the transport vehicle the transport command in which the transport destination is the first placing section disposed across the travel area with respect to the second placing section on which the article is in a state of being placed. In this configuration, after the article is stored in the first placing section, the article can be securely retrieved from the second placing section.

### Advantageous Effects of Invention

According to one aspect of the invention, efficient storage and retrieval of articles between the transport vehicle and the stocker is possible.

### Brief Description of Drawings

[FIG. 1] FIG. 1 is a perspective view illustrating an overall configuration of a transport vehicle system according to an embodiment.
[FIG. 2] FIG. 2 is a perspective view illustrating a configuration of a track in FIG. 1.
[FIG. 3] FIG. 3 is a perspective view illustrating a configuration of a transport vehicle in FIG. 1.
[FIG. 4] FIG. 4 is a side view illustrating a configuration of the transport vehicle in FIG. 1.
[FIG. 5] FIG. 5(A) is a cross-sectional view illustrating an overview configuration of a storage device in FIG. 1. FIG. 5(B) is a plan view illustrating part of a placing shelf by enlargement.

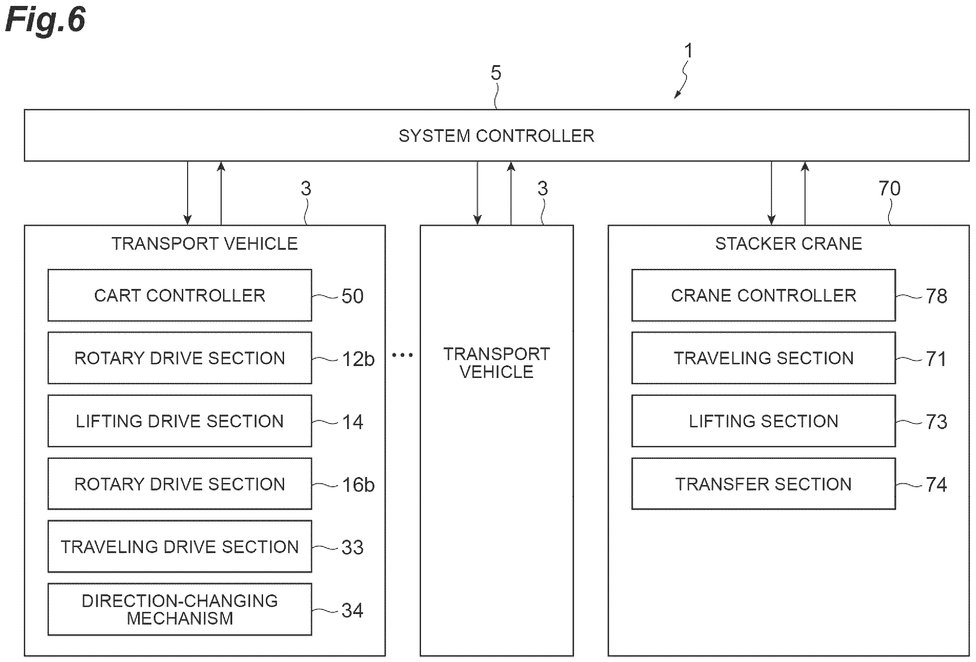

[FIG. 6] FIG. 6 is a block diagram illustrating a functional configuration of the transport vehicle system in FIG. 1.
[FIG. 7] FIG. 7(A) and FIG. 7(B) are diagrams illustrating movement of a transport vehicle during storage and retrieval of an article to and from a stocker.
[FIG. 8] FIG. 8(A) and FIG. 8(B) are diagrams illustrating movement of a transport vehicle during storage and retrieval of an article to and from a stocker.
[FIG. 9] FIG. 9(A) and FIG. 9(B) are diagrams illustrating movement of a transport vehicle during storage and retrieval of an article to and from a stocker.
[FIG. 10] FIG. 10(A) and FIG. 10(B) are diagrams illustrating movement of a transport vehicle during storage and retrieval of an article to and from a stocker.

### Description of Embodiments

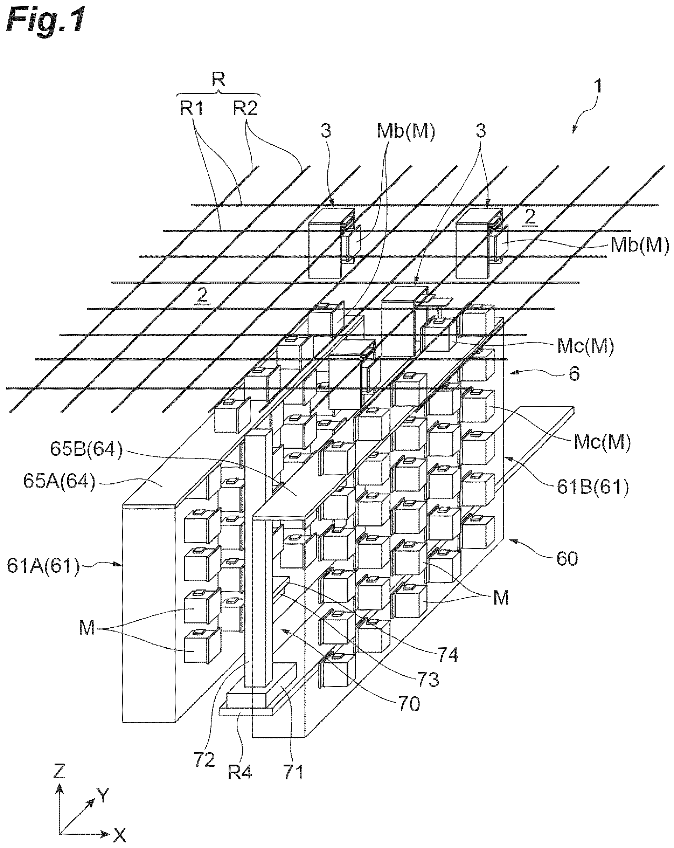

A transport vehicle system 1 according to an embodiment will now be described with reference to the attached drawings. In the description of the drawings, identical elements are marked with the same symbol and redundant explanations are omitted. Dimensional proportions in the drawings do not necessarily match those in the description. For convenience of explanation, XYZ coordinates are set in FIG. 1 to FIG. 3. In an XYZ coordinate system, an XY plane is a plane parallel to a horizontal plane. One direction along the XY plane is denoted as an X direction (first direction), and a direction orthogonal to the X direction is denoted as a Y direction (second direction). A direction perpendicular to the XY plane is denoted as a Z direction. Each of the X, Y, and Z directions is described as if the direction indicated by an arrow in the drawing is a + direction and a direction opposite to the direction indicated by the arrow is a - direction. In addition, a direction of rotation around a vertical axis or a Z axis is denoted as a θZ direction.

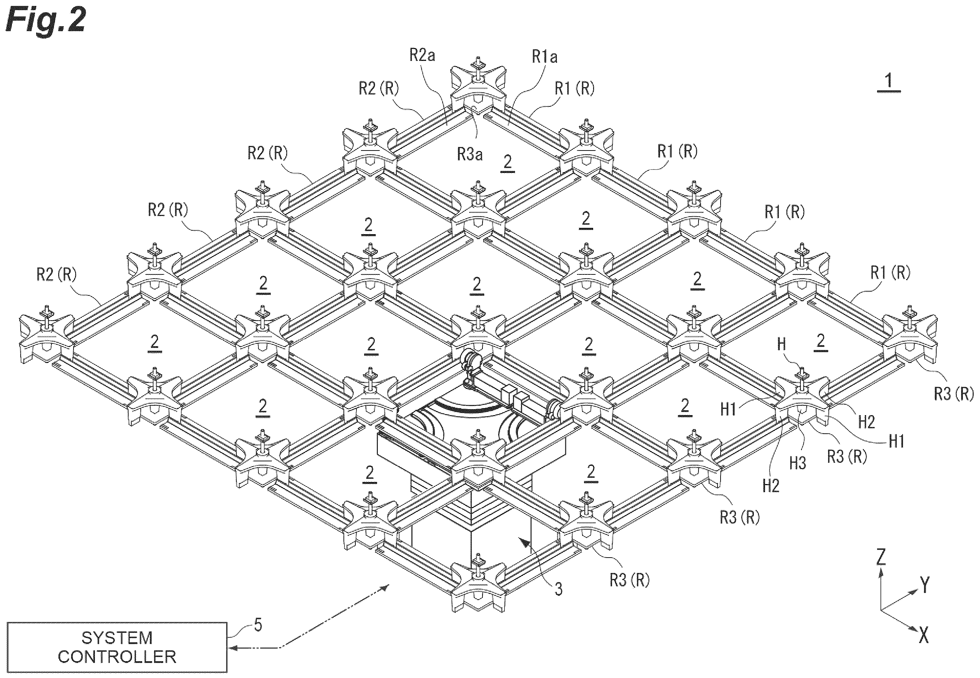

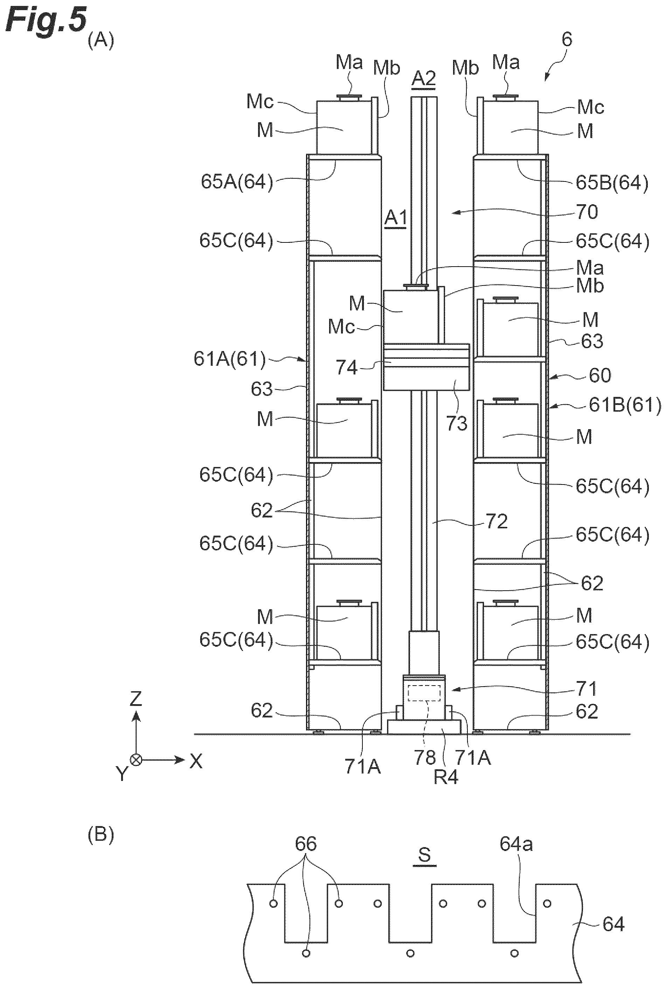

The transport vehicle system 1 illustrated in FIG. 1 and FIG. 2 is a grid system configured to transport an article M by an overhead transport vehicle 3 in a clean room of a semiconductor manufacturing plant, for example. The transport vehicle system 1 includes a track R, a plurality of transport vehicles 3, a storage device 6, and a system controller 5. The transport vehicles 3 travel on the track R provided on or near a ceiling of a building such as a clean room. The storage device 6 is disposed below the track R and has a stocker 60 configured to store the article M and a stacker crane (transfer device) 70 configured to move the article M within the stocker 60. As illustrated in FIG. 5(A), the stocker 60 includes a first rack 61A and a second rack 61B disposed to sandwich a travel area A1 of the stacker crane 70 traveling along the Y direction.

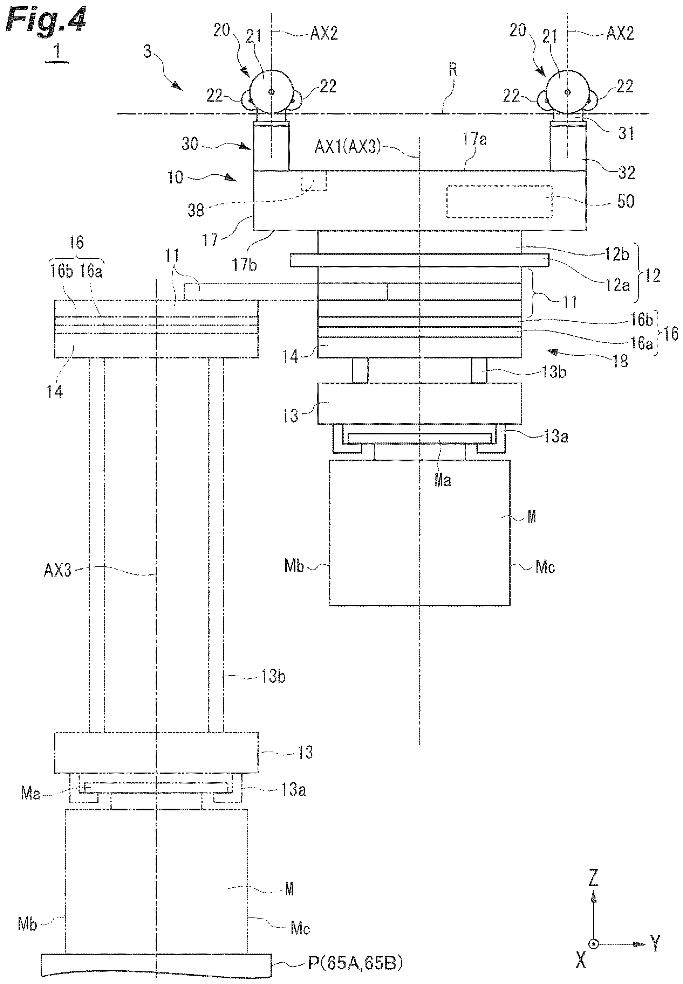

As illustrated in FIG. 1 and FIG. 2, the track R may be supported directly on the ceiling, or may be supported by a member or the like suspended from the ceiling. The track R is provided so that the article M can be transported to, for example, the storage device 6, various kinds of processing equipment, and the like. The processing equipment includes, for example, exposure equipment, coater developers, deposition equipment, etching equipment, or the like. The article M is, for example, a container in which a semiconductor wafer is housed. The processing equipment provides various kinds of processing to the semiconductor wafer in the container. The processing equipment is provided with a load port P (refer to FIG. 4) configured to exchange articles M with the transport vehicle 3. The storage device 6 stores articles M to be transported by the transport vehicle 3. The storage device 6 is provided with a storage port (first placing section) 65A and a retrieval port (second placing section) 65B configured to exchange the articles M with the transport vehicle 3. The storage port 65A and the retrieval port 65B will be described in detail in a later section.

The track R is disposed in a grid pattern in plan view. The track R is a rail extending along the horizontal direction and being suspended from the ceiling or the like. The track R has a plurality of first rails R1, a plurality of second rails R2, and a plurality of intersections R3. Hereafter, the track R is referred to as a grid pattern track R.

The first rails R1 each extend along the X direction. The second rails R2 each extend along the Y direction. The grid pattern track R is formed in a grid pattern in plan view by the first rails R1 and the second rails R2. The grid pattern track R forms a plurality of squares by the first rails R1 and the second rails R2. The intersection R3 is disposed at a portion where the first rail R1 and the second rail R2 intersect each other. The intersection R3 is adjacent to the first rail R1 in the X direction and is adjacent to the second rail R2 in the Y direction. The intersection R3 is a connecting track configured to connect the first rail R1 to the second rail R2, the first rails R1 to each other, and the second rails R2 to each other. The intersection R3 is a track used in every case when the transport vehicle 3 travels along the first rail R1, when the transport vehicle 3 travels along the second rail R2, and when the transport vehicle 3 travels from the first rail R1 to the second rail R2, or from the second rail R2 to the first rail R1.

The grid pattern track R is in a state where a plurality of grid cells (cells) 2 are adjacent to each other in plan view by being provided in a direction in which the first rails R1 and the second rails R2 are orthogonal to each other. One grid cell 2 corresponds to one square and is a rectangular area surrounded by the two first rails R1 adjacent to each other in the Y direction and the two second rails R2 adjacent to each other in the X direction in plan view. A portion of the grid pattern track R is illustrated in FIG. 1 and FIG. 2, and the grid pattern track R is formed by a series of similar configurations in the X and Y directions from the configuration illustrated in the drawings.

The first rail R1, the second rail R2, and the intersection R3 are suspended and supported on a ceiling, which is not illustrated, by a suspension member H. The suspension member H has first parts H1 configured to suspend the first rail R1, second parts H2 configured to suspend the second rail R2, and a third part H3 configured to suspend the intersection R3. The first parts H1 are respectively provided at two locations to sandwich the third part H3 and the second parts H2 are respectively provided at two locations to sandwich the third part H.

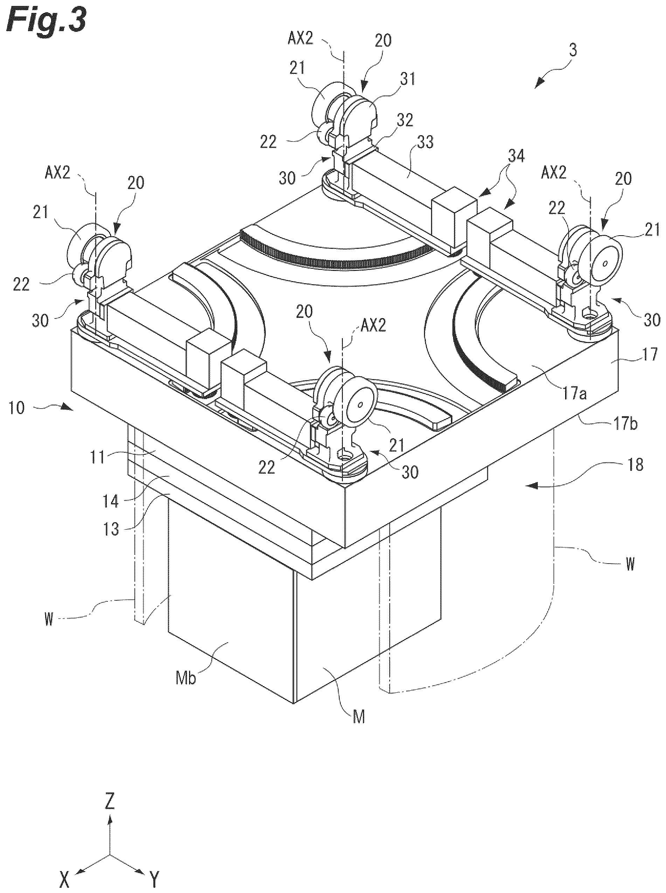

The first rail R1, the second rail R2, and the intersection R3 have travel faces R1a, R2a, and R3a, respectively, each on which traveling wheels 21 described below of the transport vehicle 3 travel. Gaps are formed between the first rail R1 and the intersection R3, and between the second rail R2 and the intersection R3, respectively. The gap between the first rail R1 and the intersection R3 and the gap between the second rail R2 and the intersection R3 are portions through which a first coupling 30 (refer to FIG. 3), described below, which is part of the transport vehicle 3, passes when the transport vehicle 3 travels on the first rail R1 and crosses the second rail R2, or when travels on the second rail R2 and crosses the first rail R1. Therefore, the gap between the first rail R1 and the intersection rail R3, and the gap between the second rail R2 and the intersection rail R3 are provided to have a width through which the first coupling 30 is passable. The first rail R1, the second rail R2, and the intersection R3 are provided along the same horizontal plane. In the present embodiment, the travel faces R1a, R2a, and R3a of the first rail R1, the second rail R2, and the intersection R3 are disposed on the same horizontal plane.

The transport vehicle 3 moves along the track R of the transport vehicle system 1. The track R is a travel path of the transport vehicle 3. The transport vehicle 3 travels along the track R of the transport vehicle system 1 and transports the article M, such as a FOUP configured to house a semiconductor wafer or a reticle Pod configured to house a reticle. As illustrated in FIG. 1 and FIG. 5(A), the present embodiment is described with an example in which a FOUP (Front-Opening Unified Pod), as one example of the article M, is transported, the FOUP having a front surface (first end) Mb being one end in one direction and being provided with a lid and a back surface (second end) Mc being the other end of the one direction and having a different shape from the front surface Mb. In addition, the bottom surface of the article M is provided with a plurality of recesses that engage pins (positioning members) 66 (refer to FIG. 5(B)), which are described in detail in a later section. The orientation of the article M is determined based on the placement of these pins 66.

The configuration of the transport vehicle 3 is described below. As illustrated in FIG. 1 to FIG. 4, the transport vehicle 3 is provided to be travelable along the grid pattern track R. The transport vehicle 3 has a first body part 10, a first traveling section 20, a first coupling 30, and a cart controller (transport vehicle control section) 50. The cart controller 50 is provided to be communicable with the system controller 5.

The first body part 10 is disposed below (the -Z direction side) of the grid pattern track R. The first body part 10 is formed in a rectangular shape, for example, in plan view. The first body part 10 is formed to dimensions fitting into one grid cell 2 in the grid pattern track R in plan view. Consequently, a space is secured that allows passing another transport vehicle 3 traveling on the adjacent first rail R1 or the adjacent second rail R2. The first body part 10 includes an upper unit 17 and a transfer section 18. The upper unit 17 is suspended from the first traveling section 20 via the first coupling 30. The upper unit 17 is rectangular in plan view, for example, and has four corners on an upper surface 17a and a lower surface 17b.

The first body part 10 has a traveling wheel 21, a first coupling 30, and a direction-changing mechanism 34 at each of the four corners of the upper surface 17a. In this configuration, with the traveling wheels 21 disposed on the four corners of the upper surface 17a of the first body part 10, the first body part 10 can be stably suspended and supported, and the first body part 10 can be stably caused to travel.

The transfer section 18 moves along the horizontal direction with respect to the first traveling section 20 and transfers articles M between the load port P in the processing equipment and the storage port 65A and the retrieval port 65B in the storage device 6. The transfer section 18 is provided below the upper unit 17. The transfer section 18 is rotatable around a rotation axis AX1 in the Z direction. The transfer section 18 has a holding section 13 configured to hold an article M on an underside of the grid pattern track R, a lifting drive section 14 configured to raise and lower the holding section 13 in the vertical direction, a first rotary section (rotary section) 16 configured to rotate the lifting drive section 14 along the horizontal direction, a sliding section 11 configured to slide and move the lifting drive section 14 in the horizontal direction, and a second rotary section 12 configured to hold the sliding section 11.

The holding section 13 holds (grips) a flange section Ma of the article M, thereby suspending and holding the article M. The holding section 13 is, for example, a chuck having a claw part 13a movable in the horizontal direction, the chuck advancing the claw part 13a below the flange section Ma of the article M to raise the holding section 13, thereby holding the article M. The holding section 13 is connected to a hanging member 13b, such as a wire or a belt.

The lifting drive section 14 is, for example, a hoist, the hoist lowering the article holding section 13 by unrolling the hanging member 13b and raising the holding section 13 by reeling in the hanging member 13b. The lifting drive section 14 is controlled by the cart controller 50 to lower or raise the holding section 13 at a predetermined speed. In addition, the lifting drive section 14 is controlled by the cart controller 50 to hold the holding section 13 at a target height.

The first rotary section 16 is provided between the sliding section 11 and the lifting drive section 14. The first rotary section 16 has a rotation member 16a and a rotary drive section 16b. The rotation member 16a is rotatably provided in the direction around the axis in the Z direction. The rotation member 16a supports the lifting drive section 14. As the rotary drive section 16b, for example, an electric motor or the like is used to rotate the rotation member 16a in the direction around the axis of a rotation axis AX3. The first rotary section 16 can rotate the rotation member 16a by the driving force from the rotary drive section 16b to rotate the lifting drive section 14 and the holding section 13 in the direction around the axis of the rotation axis AX3.

The sliding section 11 has a plurality of movable plates disposed on top of each other in the Z direction, for example. To the bottom-most movable plate, the lifting drive section 14 is attached. In the sliding section 11, the movable plates move in the horizontal plane in a direction perpendicular to the travel direction of the transport vehicle 3, and the lifting drive section 14 and holding section 13 attached to the bottom-most movable plate move laterally (slide movement) in a direction perpendicular to the travel direction of the transport vehicle 3.

The second rotary section 12 is provided between the sliding section 11 and the upper unit 17. The second rotary section 12 has a rotation member 12a and a rotary drive section 12b. The rotation member 12a is rotatably provided in the direction around the axis in the Z direction. The rotation member 12a supports the sliding section 11. As the rotary drive section 12b, for example, an electric motor or the like is used to rotate the rotation member 12a in the direction around the axis of the rotation axis AX1. The second rotary section 12 can rotate the rotation member 12a by the driving force from the rotary drive section 12b and can rotate the sliding section 11 (the lifting drive section 14 and the holding section 13) in the direction around the axis of the rotation axis AX1. The transport vehicle 3 can receive and deliver the article M to and from the load port P, the storage port 65A, and the retrieval port 65B by using the transfer section 18.

In a state where the sliding section 11 is not sliding and moving the lifting drive section 14 and the holding section 13, the rotation axis AX1 and the rotation axis AX3 are coincident.

The transport vehicle 3 may be provided with a cover W. The cover W encloses the transfer section 18 and the article M held in the transfer section 18. The cover W has a shape with a lower end open and with a cutout portion from which a movable plate of the sliding section 11 protrudes. The cover W has an upper end attached to the rotation member 12a of the second rotary section 12 and rotates around the axis of the rotation axis AX1 as the rotation member 12a rotates.

The first traveling section 20 has traveling wheels 21 and auxiliary wheels 22. The traveling wheels 21 are respectively disposed at the four corners of the upper surface 17a of the upper unit 17 (first body part 10). Each of the traveling wheels 21 is attached to an axle on the first coupling 30. Each of the traveling wheels 21 is rotationally driven by the driving force of a traveling drive section 33. Each of the traveling wheels 21 rolls on the grid pattern track R. Each of the traveling wheels 21 rolls on the travel faces R1a, R2a, and R3a of the first rail R1, the second rail R2, and the intersection rail R3 to drive the transport vehicle 3. It is not limited to that all of the four traveling wheels 21 are rotationally driven by the driving force of the traveling drive section 33, but there may be a configuration in which some of the four traveling wheels 21 are rotationally driven.

The traveling wheels 21 are rotatably provided around a rotation axis AX2 in the θZ direction. The traveling wheel 21 can rotate by the direction-changing mechanism 34, which will be described later, in the θZ direction, and thus can change the travel direction of the transport vehicle 3. The auxiliary wheels 22 are disposed one each in front of and behind the traveling wheel 21 in the travel direction. Each of the auxiliary wheels 22 is rotatable around the axis of a horizontal or nearly horizontal axle along the XY plane, similarly to the traveling wheels 21. The lower end of the auxiliary wheel 22 is set higher than the lower end of the traveling wheel 21. Therefore, when the traveling wheels 21 are traveling on the travel faces R1a, R2a, and R3a, the auxiliary wheels 22 do not contact the travel faces R1a, R2a, and R3a.

In addition, when the traveling wheels 21 pass through the gaps between the first rail R1 and the intersection rail R3, and between the second rail R2 and the intersection rail R3, the auxiliary wheels 22 contact the travel faces R1a, R2a, and R3a to prevent the traveling wheels 21 from falling. It is not limited to that the two auxiliary wheels 22, 22 are provided on one traveling wheel 21, but on one traveling wheel 21, for example, one auxiliary wheel 22 may be provided or no auxiliary wheel 22 may be provided.

The first coupling 30 couples the upper unit 17 of the first body part 10 to the first traveling section 20. The first coupling 30 is provided at each of the four corners of the upper surface 17a of the upper unit 17 (first body part 10). By the first coupling 30, the first body part 10 becomes a state of being suspended from the first traveling section 20 and is positioned below the grid pattern track R. The first coupling 30 has a support member 31 and a connection member 32. The support member 31 rotatably supports a rotation shaft of the traveling wheel 21 and a rotation shaft of the auxiliary wheel 22. The support member 31 holds a relative position of the traveling wheel 21 and the auxiliary wheel 22. The support member 31 is formed to be, for example, a plate shape, and formed to be thick enough to pass through the gaps between the first rail R1 and the intersection R3, and between the second rail R2 and the intersection R3.

The connection member 32 extends downward from the support member 31 and is coupled to the upper surface 17a of the upper unit 17 to hold the upper unit 17. The connection member 32 includes a transmission mechanism inside configured to transmit the driving force of the traveling drive section 33, which will be described below, to the traveling wheels 21. The transmission mechanism may have a configuration in which a chain or belt is used, or a configuration in which a gear train is used. The connection member 32 is rotatably provided in the θZ direction around the rotation axis AX2. The connection member 32 rotates around the rotation axis AX2, and thus can rotate the traveling wheel 21 in the θZ direction around the rotation axis AX2 via the support member 31.

The first coupling 30 is provided with the traveling drive section 33 and the direction-changing mechanism 34. The traveling drive section 33 is attached to the connection member 32. The traveling drive section 33 is a drive source configured to drive the traveling wheels 21, and an electric motor, for example, or the like is used. Each of the four traveling wheels 21 is a drive wheel driven by the traveling drive section 33. The four traveling wheels 21 are controlled by the cart controller 50 to have the same number of revolutions per unit time.

The direction-changing mechanism 34 rotates the connection member 32 of the first coupling 30 around the rotation axis AX2, thereby rotating the traveling wheel 21 in the θZ direction around the rotation axis AX2. By rotating the traveling wheels 21 in the θZ direction, it is possible to switch from a first state in which the travel direction of the transport vehicle 3 is the X direction to a second state in which the travel direction is the Y direction, or from the second state in which the travel direction is the Y direction to the first state in which the travel direction is the X direction. The rotation of the direction-changing mechanism 34 causes each of the traveling wheels 21 and each of the auxiliary wheels 22 disposed at the four corners of the upper surface 17a to rotate within a range of 90 degrees in the θZ direction around the rotation axis AX2.

The drive of the direction-changing mechanism 34 is controlled by the cart controller 50. By rotating the traveling wheels 21 and auxiliary wheels 22, the traveling wheels 21 shift from a state of being in contact with one of the first rail R1 and the second rail R2 to a state of being in contact with the other. Consequently, it is possible to switch between the first state in which the travel direction of the transport vehicle 3 is the X direction and the second state in which the travel direction is the Y direction.

The transport vehicle 3 moves in the X direction when the first traveling section 20 travels on the pair of first rails R1, R1 adjacent to each other in the Y direction, and moves in the Y direction when the first traveling section 20 travels on the pair of second rails R2, R2 adjacent to each other in the X direction.

The transport vehicle 3 includes a position detection section 38 configured to detect position information. The position detection section 38 detects the current position of the transport vehicle 3 by detecting position markers (not illustrated) indicating position information. The position detection section 38 detects position markers in a non-contact manner. The position markers are installed on the first rail R1 and the second rail R2 of the grid pattern track R.

The cart controller 50 controls the transport vehicle 3 in an overall manner. The cart controller 50 is a computer including a CPU (Central Processing Unit), a ROM (Read Only Memory), a RAM (Random Access Memory), and the like. The cart controller 50 can be configured as software, for example, with which a computer program stored in the ROM is loaded onto the RAM and executed by the CPU. The cart controller 50 may be configured as hardware using an electronic circuit or the like. The cart controller 50, which is exemplarily illustrated as being installed in the first body part 10 in the present embodiment, may be installed outside of the first body part 10.

The cart controller 50 controls the traveling of the transport vehicle 3 based on transport instructions. The cart controller 50 controls the traveling of the transport vehicle 3 by controlling the traveling drive section 33 the direction-changing mechanism 34, and the like. The cart controller 50 controls, for example, travel speed, operations related to stopping, and operations related to direction changes. The cart controller 50 controls the transfer operation of the transport vehicle 3 based on the transport instructions. The cart controller 50 controls the transfer operation of the transport vehicle 3 by controlling the transfer section 18 and the like. The cart controller 50 controls the operation of loading in which the articles M disposed at a specified load port P and the retrieval port 65B are held (received) by the holding section 13, and the operation of unloading in which the articles M held in the holding section 13 are unloaded (delivered) to the specified load port P and the storage port 65A.

The cart controller 50 controls the first traveling section 20, the lifting drive section 14, and the sliding section 11 so that the article M held by the holding section 13 is delivered to the storage port 65A and the article M placed on the retrieval port 65B is received, in a state of being stopped at a stopping position (specific stopping position) between the storage port 65A and the retrieval port 65B. The cart controller 50 rotates the first rotary section 16 so that the front surface Mb with the lid faces the second rack 61B when the article M is placed on the first rack 61A, and rotates the first rotary section 16 so that the front surface Mb with the lid faces the first rack 61A when the article M is placed on the second rack 61B. The cart controller 50 does not rotate the first rotary section 16 in a case where the orientation of the front surface Mb is as described above before the article M is placed on each rack.

As illustrated in FIG. 1, FIG. 5(A), and FIG. 5(B), the storage device 6 has the stocker 60 and the stacker crane 70, as described above. In the stocker 60, the article M transported by the transport vehicle 3 is stored. The stocker 60 stores the articles M in a state of being arrayed in the horizontal direction and the vertical direction. The stocker 60 in the present embodiment includes the first rack 61A and the second rack 61B disposed so as to sandwich the travel area A1 of the stacker crane 70 traveling along the Y direction. Each of the first rack 61A and the second rack 61B has a placing section with five rows and six tiers on which the five articles M can be arrayed in the horizontal direction and the six articles M can be arrayed in the vertical direction. The placing section includes the storage port 65A, the retrieval port 65B, and the storage section 65C.

The stacker crane 70 moves the articles M on the first rack 61A and the second rack 61B inside the stocker 60. In other words, the stacker crane 70 exchanges the articles M between the placing sections of the first rack 61A, exchanges the articles M between the placing sections of the second rack 61B, and exchanges the articles M between the placing sections of the first rack 61A and the second rack 61B.

Each of the first rack 61A and the second rack 61B has a frame 62, a panel 63, and a placing shelf 64. The frame 62 is a member extending in one direction and disposed along the X, Y, and Z directions to support the panel 63 and the placing shelf 64. The panel 63 is a member of a plate shape covering part of each of the first rack 61A and the second rack 61B. In the first rack 61A, when the side facing the travel area A1 of the stacker crane 70 is the front side, the panels 63 are disposed at the rear side in the first rack 61A and at both sides in the travel direction (Y direction) of the stacker crane 70 in the first rack 61A. In other words, the panels 63 form the rear (back) side and the sides of the first rack 61A. In the second rack 61B also, the panels 63 are disposed in positions similar to those in the first rack 61A.

The placing shelf 64 is a member on which the article M is placed and a member included in the placing section of the article **M.** The placing shelf 64 is provided so as to be able to support both ends in the Y direction and the rear end in the X direction on the lower surface of the article M from below. In other words, the article M placed on the placing shelf 64 is supported by the support members at both ends and at the rear end in the Y direction of the lower surface of the article M. The placing shelf 64 is provided with pins (positioning members) 66 for positioning the article M. The pin 66 is a convex portion formed to engage a recess or the like formed in the back of the article M.

In the present embodiment, the positioning member for positioning one article M includes three pins 66, 66, 66. When the article M is placed on the placing shelf 64 so as to engage with the three pins 66, 66, 66, the front surface Mb of the article M faces forward. Consequently, the articles M stored in the first rack 61A and the second rack 61B, which are disposed to face each other across the travel area A1 of the stacker crane 70, are placed on the placing shelves 64 in a state where the front surfaces Mb face each other.

The placing shelf 64 is set up with the storage port 65A as a placing section for storage, the retrieval port 65B as a placing section for retrieval, and the storage section 65C as a placing section exclusively for storage. The storage port 65A and the retrieval port 65B are set on the uppermost row of the rack 61. In the present embodiment, in a pair of racks 61, 61, the five storage ports 65A are set on the uppermost row of the first rack 61A as one rack 61, and the five retrieval ports 65B are set on the uppermost row of the second rack 61B as the other rack 61. The storage ports 65A and the retrieval ports 65B are set to face each other across the travel area A1 of the stacker crane 70 and the travel area A2 of the transport vehicle 3. It is sufficient to have at least one storage port 65A and at least one retrieval port 65B set on the uppermost row of the rack 61. A plurality of the storage sections 65C are arrayed in the vertical direction (Z direction) and in the horizontal (Y direction) below the storage port 65A and the retrieval port 65B.

The stacker crane 70 includes a traveling section 71, a mast 72, a lifting section 73, a transfer section 74, and a crane controller 78. The crane controller 78 is provided to be communicable with the system controller 5.

In the traveling section 71, a traveling motor and a lifting motor, which are not illustrated, are disposed. The traveling section 71 has traveling wheels 71A and travels along a traveling rail R4 laid on the ground. The traveling section 71 travels when the traveling wheels 71A driven by the traveling motor roll on the traveling rail R4. The mast 72 is a square cylindrical member extending in the vertical direction and is erected on the traveling section 71. The lifting section 73 is liftably provided along an extending direction of the mast 72. The lifting section 73 is raised and lowered by the driving force of the lifting motor.

The transfer section 74 is provided on the lifting section 73 and is liftably provided in an integral manner with the lifting section 73. The transfer section 74 takes out articles M from the placing shelf 64 and places articles M on the placing shelf 64. More precisely, the transfer section 74 exchanges articles M between the storage port 65A and the storage section 65C, between the storage sections 65C different from each other, and between the storage section 65C and the retrieval port 65B. The transfer section 74 is formed to be able to support the articles M from below.

The transfer section 74 advances the article M in a state of being supported at both ends in the Y direction by the placing shelf 64, below a vicinity of a center portion in the Y direction and moves the article M upward through a cutout portion 64a in the placing shelf 64, thereby supporting the article M from below to receive the article M from the placing shelf 64. The transfer section 74 advances the article M in a state of being supported from below the vicinity of the center in the Y direction of the article M, above the placing shelf 64 and moves the article M downward through the cutout portion 64a of the placing shelf 64, thereby allowing the placing shelf 64 to support both ends in the Y direction on the lower surface of the article M, to deliver the article M to the placing shelf 64.

The crane controller 78 moves the article M within the stocker 60 by the command from the system controller 5. For example, by the command from the system controller 5, the article M stored in the storage port 65A is moved to the predetermined storage section 65C, or the article M stored in the predetermined storage section 65C is moved to the retrieval port 65B.

The system controller 5 controls the transport vehicles 3 and the storage device 6 in an overall manner. The system controller 5 is a computer including a CPU, a ROM, a RAM, and the like. The system controller 5 can be configured as software, for example, with which a computer program stored in the ROM is loaded onto the RAM and executed by the CPU. The system controller 5 may be configured as hardware using an electronic circuit or the like.

The system controller 5 outputs to the transport vehicle 3 the transport command instructing a transport destination of the article M. The system controller 5 according to the present embodiment outputs to the transport vehicle 3, in a case of storage and retrieval of articles M by the transport vehicle 3 to and from the stocker 60, the transport command in which the transport destination is the storage port 65A disposed across the travel area A2 of the transport vehicle 3 with respect to the retrieval port 65B on which the article M is in a state of being placed. Based on the above transport command, the transport vehicle 3 travels on the track R to move to the stopping position between the storage port 65A and the retrieval port 65B. The transport vehicle 3 stopped at the stopping position delivers the article M to the storage port 65A and receives the article M from the retrieval port 65B. The system controller 5 monitors the status of the presence of the article M (presence or absence of the article M at each placing section) based on the transport completion information transmitted periodically from the cart controller 50 and the crane controller 78.

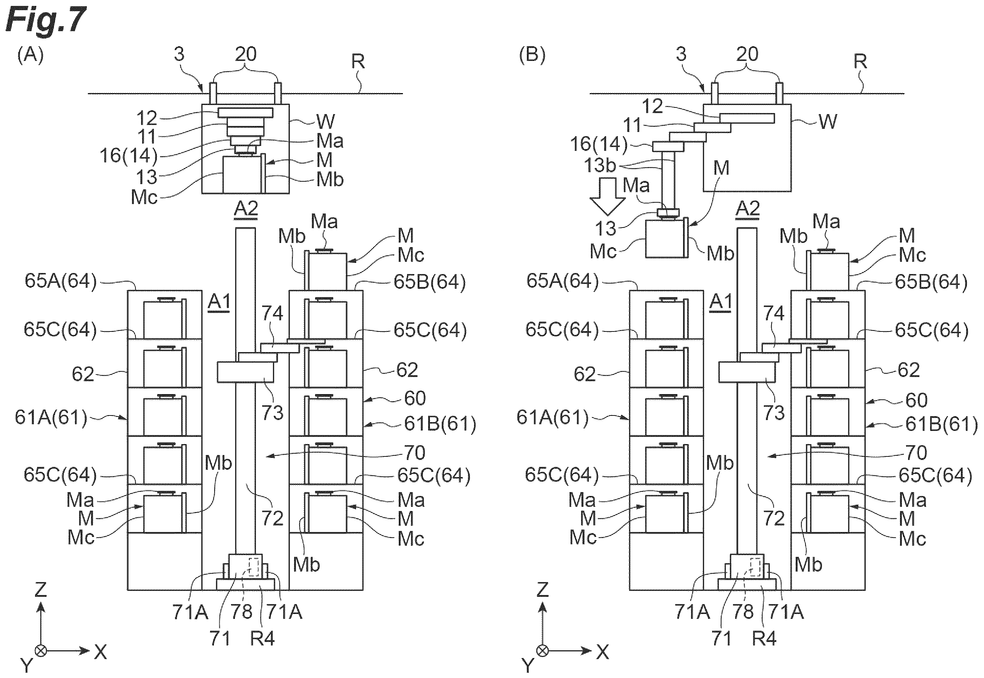

Next, the operations during storage and retrieval of articles M by the transport vehicle 3 according to the present embodiment to and from the stocker 60 will be explained mainly using FIG. 7(A) to FIG. 10(B).

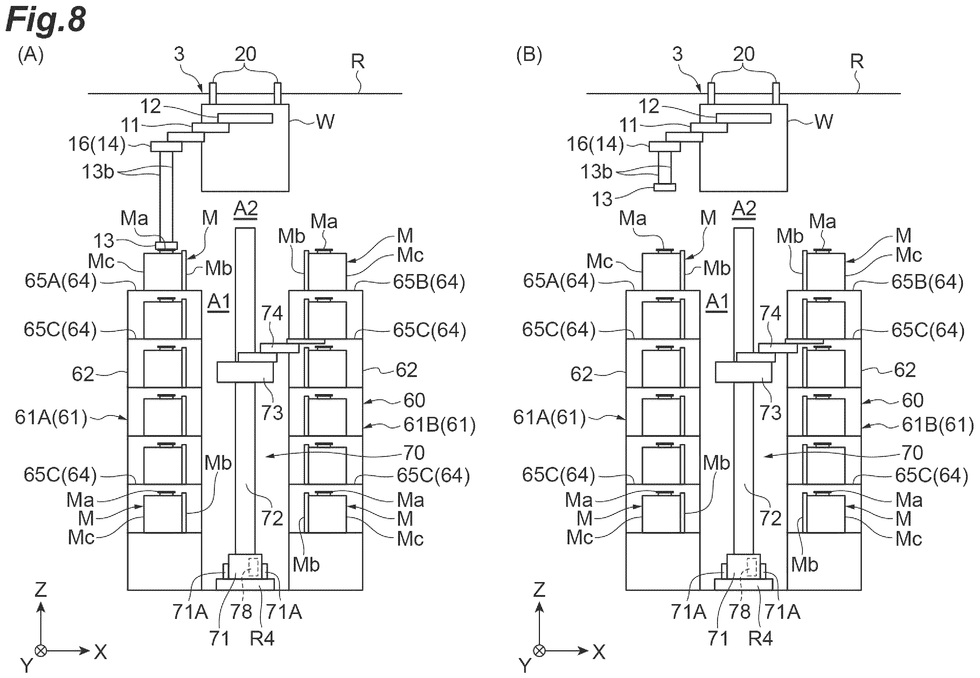

In a case of storage and retrieval of articles M by the transport vehicle 3 to and from the stocker 60, the system controller 5 outputs to the transport vehicle 3 a transport command in which the transport destination is the storage port 65A disposed across the travel area A2 of the transport vehicle 3 with respect to the retrieval port 65B on which the article M is in a state of being placed. The transport vehicle 3 having received the transport command, as illustrated in FIG. 7(A), stops at the stopping position (specific stopping position) between the storage port 65A and the retrieval port 65B in a state of holding the article M. Next, as illustrated in FIG. 7(B), the transport vehicle 3 drives the sliding section 11 to move the holding section 13 to the -X direction side up to above the storage port 65A of the first rack 61A. Next, as illustrated in FIG. 8(A), the transport vehicle 3 drives the lifting drive section 14 to lower the holding section 13, thereby placing (delivering) the article M on the storage port 65A.

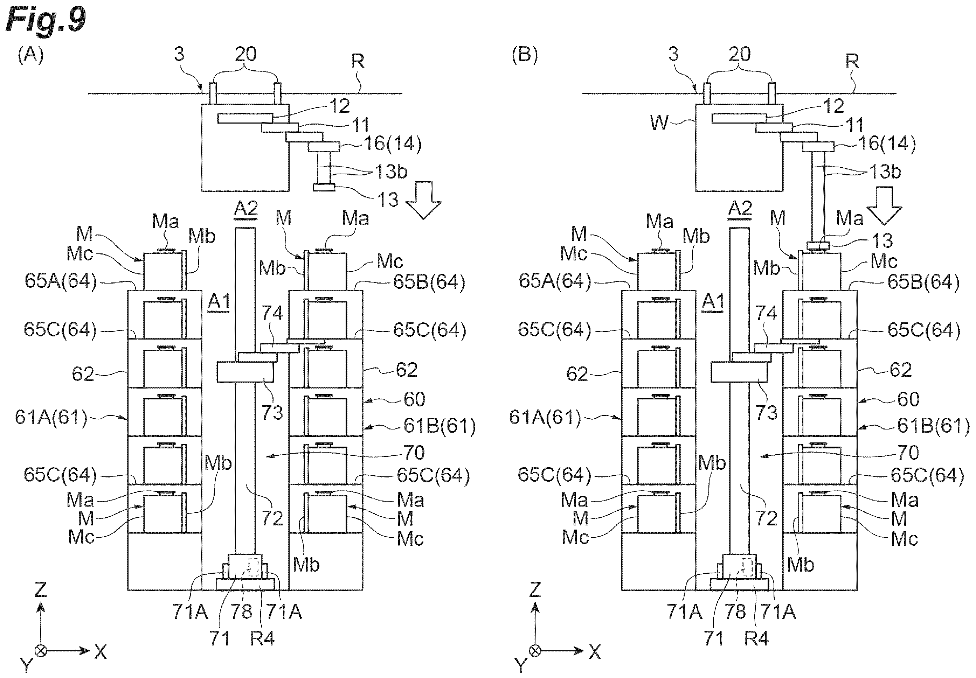

Next, as illustrated in FIG. 8(B), the transport vehicle 3 releases the holding of the article M by the claw part 13a, and drives the lifting drive section 14 to raise the holding section 13 up to above the storage port 65A. Next, as illustrated in FIG. 9(A), the transport vehicle 3 drives the sliding section 11 to move the holding section 13 to the +X direction side up to above the retrieval port 65B of the second rack 61B. Next, as illustrated in FIG. 9(B), the transport vehicle 3 drives the lifting drive section 14 to lower the holding section 13.

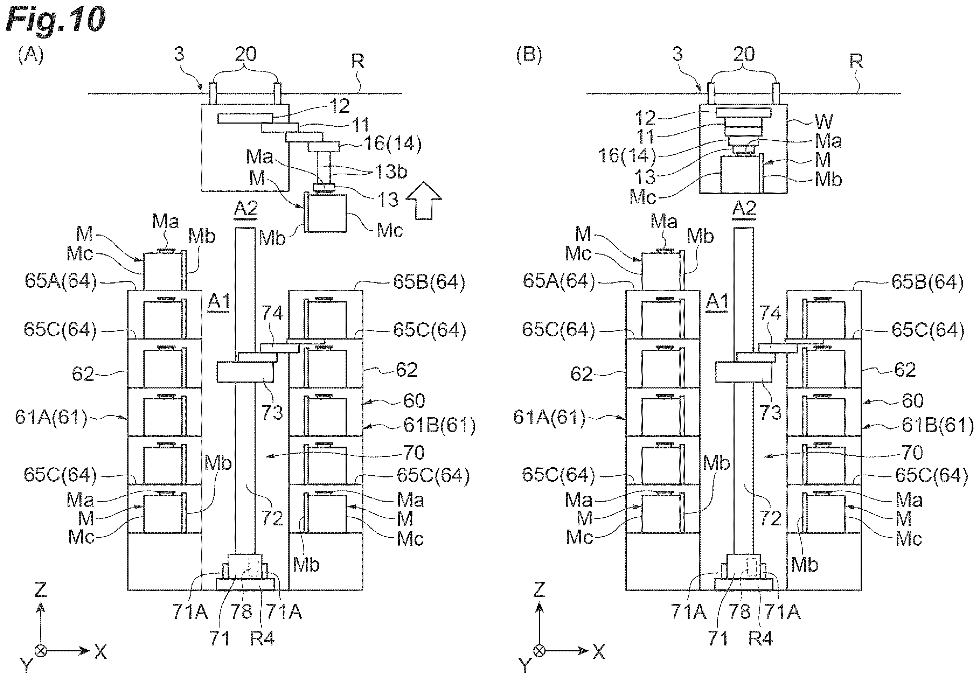

Next, as illustrated in FIG. 10(A), the transport vehicle 3 in a state of holding the article M by the claw part 13a drives the lifting drive section 14 to raise the holding section 13 up to above the retrieval port 65B. Consequently, the transport vehicle 3 receives the article M from the retrieval port 65B. Next, as illustrated in FIG. 10(B), the transport vehicle 3 drives the sliding section 11 to move the holding section 13 to the -X direction side to the predetermined position from which the transport vehicle 3 transports the article M in a state of holding the article M. Next, the transport vehicle 3 moves to the transport destination following the command of the system controller 5.

The effects of the transport vehicle system 1 in the above embodiment will be described. In the transport vehicle system 1 according to the above embodiment, while stopped at the specific stopping position, the transport vehicle 3 controls the first traveling section 20, the lifting drive section 14, and the sliding section 11 so as to deliver the article M held by the holding section 13 to the storage port 65A and receive the article M placed on the retrieval port 65B, instead of performing storage and retrieval between the transport vehicle 3 and the stocker 60 after the transport vehicle 3 stores an article M in the storage port 65A in which the article M is to be stored and then moves to the retrieval port 65B from which an article M is to be retrieved. Consequently, without moving of the transport vehicle 3, the article M is stored in the stocker 60, and furthermore, the article M is retrieved from the stocker 60. As a result, efficient storage and retrieval of articles between the transport vehicle 3 and the stocker 60 is possible.

In the transport vehicle system 1 according to the above embodiment, the storage port 65A and the retrieval port 65B are set to be disposed across the travel area A2 of the transport vehicle 3 and the travel area A1 of the stacker crane 70 in plan view viewed from above in the vertical direction. Furthermore, the stopping position (specific stopping position) of the transport vehicle 3 when the transport vehicle 3 stores the article M in the stocker 60 is set between the storage port 65A and the retrieval port 65B. Consequently, the control of the simple sliding section 11 configured to move the article M along one direction allows storage and retrieval of the article M to and from the stocker 60.

In the transport vehicle system 1 according to the above embodiment, the stocker 60 has the first rack 61A and the second rack 61B disposed to face each other across the travel area A2 of the transport vehicle 3 and the travel area A1 of the stacker crane 70 in plan view viewed from above in the vertical direction, the storage port 65A is set in the first rack 61A, and the retrieval port 65B is set in the second rack 61B. Furthermore, the stopping position (specific stopping position) of the transport vehicle 3 when the transport vehicle 3 stores the article M in the stocker 60 is set between the storage port 65A and the retrieval port 65B. Consequently, the control of the simple sliding section 11 configured to move the article M along one direction allows storage and retrieval of the article M to and from the stocker 60.

In the transport vehicle system 1 according to the above embodiment, the transport vehicle 3 has the first rotary section 16 configured to rotate the holding section 13 within a horizontal plane. Consequently, even when the pins 66 are provided to position the articles M so that the front surfaces Mb of the articles M to be disposed to face each other in the first rack 61A and the second rack 61B disposed to face each other, it is possible to cause the articles M to be delivered and received in the predetermined state by the first rotary section 16 rotating the holding section 13. As a result, there is no need to provide a mechanism on the storage device side to adjust the orientation of the article M when placed on the placing section.

In the transport vehicle system 1 according to the above embodiment, in the track R, a plurality of the first rails R1 extending in the X direction and the second rail R2 extending in the Y direction orthogonal to the X direction are disposed in a grid pattern, and the transport vehicle 3 moves in the X direction when the first traveling section 20 travels on the pair of first rails R1, R1 adjacent to each other in the Y direction, and moves in the Y direction when the first traveling section 20 travels on the pair of second rails R2, R2 adjacent to each other in the X direction. In this configuration, more efficient storage and retrieval of articles M is possible.

In the transport vehicle system 1 according to the above embodiment, the system controller 5 outputs to the transport vehicle a transport command in which the transport destination is the storage port 65A disposed across the travel area A2 of the transport vehicle 3 with respect to the retrieval port 65B on which the article M is in a state of being placed, and thus after the article M is stored in the storage port 65A, the article M can be securely retrieved from the retrieval port 65B.

Although one embodiment is described above, one aspect of the present invention is not limited to the above embodiment. Various modifications can be made without departing from the intent of the invention.

The transport vehicle system 1 according to the above embodiment is described with an example in which the transport vehicle 3 travels on the track R disposed in a grid pattern, but is not limited to this. For example, the track R may extend in one direction, and the transport vehicle 3 may be a transport vehicle (Overhead Hoist Transfer: OHT) having a configuration of traveling in the extending direction of the track R. Even in this case, the storage port 65A and the retrieval port 65B only need be set in a state of sandwiching the specific stopping position of the track R by installing the first rack 61A and the second rack 61B across the travel area A2 of the transport vehicle 3, or installing the first rack 61A and the second rack 61B to be orthogonal to the travel area A2 of the transport vehicle 3. Even in this case, the same effects as in the above embodiment can be enjoyed.

The transport vehicle system 1 according to the above embodiment and the modification is described with an example in which the stocker 60 includes two racks (first rack 61A and second rack 61B), but is not limited to this. For example, the stocker 60 may include a single rack 61 or the three or more racks 61.

For example, in a case where the stocker 60 includes a single rack 61, the rack 61 only need be disposed along the track R directly below the track R or disposed to intersect the track R below the track R in plan view viewed from above. The phrase "disposed along the track R directly under the track R" means that the rack 61 is disposed so that its extending direction and the extending direction of the first rail R1 or the second rail R2 are aligned (parallel) in a case where the transport vehicle 3 travels along the grid pattern track R as in the above embodiment, or means that the rack 61 is disposed so that its extending direction and the extending direction of the track R are aligned (parallel) in a case where the transport vehicle 3 travels along the track R extending in one direction as in the above modification. In this case, for example, one location above the rack 61 only need be set as a specific stopping position, and the storage port 65A and the retrieval port 65B be set to sandwich the specific stopping position above in plan view.

In addition, the phrase "disposed to intersect the track R below the track R" means that the rack 61 is disposed so that its extending direction and any of the extending direction of the first rail R1 or the second rail R2 are not aligned (not parallel) in a case where the transport vehicle 3 travels along the grid pattern track R as in the above embodiment, or means that the rack 61 is disposed so that its extending direction and the extending direction of the track R are not aligned (not parallel) in a case where the transport vehicle 3 travels along the track R extending in one direction as in the above modification. In this case, for example, the intersection of the rack 61 and the track R in plan view only need be set as a specific stopping position, and the storage port 65A and the retrieval port 65B be set to sandwich the specific stopping position above in plan view.

The transport vehicle system 1 according to the above embodiment and the modification is described with an example in which, in a case where the articles M are stored and retrieved by the transport vehicle 3 to and from the stocker 60, storage and retrieval is performed in a state where the sliding section 11 is driven to move the holding section 13 from the first body part 10 in the horizontal direction, but is not limited to this example. For example, in a case where the article M is stored in the stocker 60 by the transport vehicle 3, storage may be performed by lowering the holding section 13 directly downward without driving the sliding section 11, and only in a case where the article M is retrieved from the stocker 60 by the transport vehicle 3, retrieval may be performed in a state where the holding section 13 is moved from the first body part 10 in the horizontal direction. In other words, in a case where the transport vehicle 3 performs storage and retrieval of the articles M to and from the stocker 60, one of storage and retrieval of the article M may be performed not in a state where the sliding section 11 is driven to move the holding section 13 from the first body part 10 in the horizontal state, but by lowering the holding section 13 directly downward.

The transport vehicle system 1 according to the above embodiment and the modification is described with an example in which the system controller 5 outputs to the transport vehicle 3 the transport command in which a transport destination is the storage port 65A disposed across the travel area A2 of the transport vehicle 3 with respect to the retrieval port 65B on which the article M is in a state of being placed, but is not limited to this. For example, the system controller 5, after outputting to the transport vehicle 3 a transport command in which the transport destination is the storage port 65A, may control the stacker crane 70 to move the article M from another placing section to the retrieval port 65B disposed across the travel area A2 of the transport vehicle 3 with respect to the storage port 65A as the above transport destination.

The transport vehicle system 1 according to the above embodiment and the modification is described with an example in which the racks 61 are disposed by being aligned in the extending direction of the track R (X direction or Y direction), but the racks 61 may be disposed obliquely (with an angle) with respect to the extending direction of the track R. Even in this case, the transport vehicle 3 can place the article M on the placing section configured in the rack 61 by driving the second rotary section 12.

### Reference Signs List

- 1: Transport vehicle system
- 3: Transport vehicle
- 5: System controller
- 6: Storage device
- 11: Sliding section
- 13: Holding section
- 14: Lifting drive section
- 16: First rotary section (rotary section)
- 18: Transfer section
- 20: First traveling section (traveling section)
- 50: Cart controller (transport vehicle control section)
- 60: Stocker
- 61: Rack
- 61A: First rack
- 61B: Second rack
- 64: Placing shelf
- 65A: Storage port (first placing section)
- 65B: Retrieval port (second placing section)
- 65C: Storage section
- 66: Pin (positioning member)
- 70: Stacker crane (transfer equipment)
- M: Article
- Ma: Flange section
- Mb: Front surface (first end)
- Mc: Back surface (second end)
- R: Grid pattern track (track)
- R1: First rail
- R2: Second rail

## Claims

1. A transport vehicle system comprising a transport vehicle configured to travel on a track provided on a ceiling of a building to transport an article, and a storage device configured to store the articles, wherein
the transport vehicle has
a traveling section configured to travel on the track,
a holding section configured to hold the article,
a lifting drive section configured to raise and lower the holding section with respect to the traveling section,
a sliding section configured to move the holding section and the lifting drive section in a horizontal direction with respect to the traveling section, and
a transport vehicle control section configured to control the transport vehicle,
the storage device has
a stocker having a rack in which a plurality of placing sections arranged vertically and horizontally are disposed, and
a transfer device configured to deliver the article to the placing sections,
among the placing sections disposed in an uppermost row of the rack, at least one first placing section for storage and at least one second placing section for retrieval are set, and
the transport vehicle control section controls the traveling section, the lifting drive section, and the sliding section so as to deliver the article held by the holding section to the first placing section and receive the article placed on the second placing section, in a state of being stopped at a specific stopping position.

2. The transport vehicle system according to claim 1, wherein
the first placing section and the second placing section are set to be in a state of being disposed to sandwich a travel area of the transport vehicle in plan view viewed from above in a vertical direction, and
the specific stopping position is set between the first placing section and the second placing section in the plan view.

3. The transport vehicle system according to claim 1,
wherein
the stocker has a first rack and a second rack disposed to face each other across the travel area of the transport vehicle in plan view viewed from above a vertical direction,
the first placing section is set on the first rack, and the second placing section is set on the second rack, and
the specific stopping position is set between the first placing section and the second placing section in the plan view.

4. The transport vehicle system according to claim 3,
wherein
the transport vehicle further has a rotary section configured to rotate the holding section within a horizontal plane,
the article has a first end that is one end in one direction and a second end that is another end in the one direction and has a different shape from the first end,
a positioning member is provided in the placing section of the rack, the positioning member being configured to position the article so that the first ends of the articles placed on the racks are disposed to face each other, and
the transport vehicle control section rotates the rotary section so that the first end faces the second rack when the article is placed on the first placing section.

5. The transport vehicle system according to any one of claims 1 to 4, wherein
in the track, a plurality of first rails extending in a first direction and being arrayed in a second direction orthogonal to the first direction and second rails extending in the second direction and being arrayed in the first direction are disposed in a grid pattern, and
the transport vehicle moves in the first direction when the traveling section travels on a pair of the first rails adjacent to each other in the second direction, and moves in the second direction when the traveling section travels on a pair of the second rails adjacent to each other in the first direction.

6. The transport vehicle system according to claim 2 or 3, further comprising a system controller configured to output to the transport vehicle a transport command instructing a transport destination of the article, wherein
the system controller outputs to the transport vehicle the transport command in which the transport destination is the first placing section disposed across the travel area with respect to the second placing section on which the article is in a state of being placed.
